# EUROPÄISCHE PATENTSCHRIFT

(11) **EP 0 868 405 B1**
(45) Veröffentlichungstag und Bekanntmachung des Hinweises auf die Patenterteilung: **29.09.1999**
(21) Anmeldenummer: 96946204.3
(22) Anmeldetag: 13.12.1996
(51) Int. Cl.: C03C 17/36, C23C 14/54, C23C 14/00

(54) **VERFAHREN ZUR HERSTELLUNG WÄRMEREFLEKTIERENDER SCHICHTSYSTEME AUF TRANSPARENTEN SUBSTRATEN**
PROCESS FOR PRODUCING HEAT-REFLECTING LAMINATED SYSTEMS ON TRANSPARENT SUBSTRATES
PROCEDE PERMETTANT DE PRODUIRE DES SYSTEMES FEUILLETES REFLECHISSANT LA CHALEUR SUR DES SUBSTRATS TRANSPARENTS

(30) Priorität: 22.12.1995 DE 19548430
(43) Veröffentlichungstag der Anmeldung: 07.10.1998
(73) Patentinhaber: Arcon Flachglas-Veredlung GmbH & Co. Beschichtungstechnik KG, 91555 Feuchtwangen (DE)
(72) Erfinder: KIRCHHOFF, Volker, D-01324 Dresden (DE); HARTUNG, Ullrich, D-01129 Dresden (DE); SÖDER, Bernhard, D-91639 Wolframs-Eschenbach (DE); GRÖNINGER, Emil, D-91207 Lauf (DE)
(86) Internationale Anmeldenummer: DE9602429
(87) Internationale Veröffentlichungsnummer: WO9723425

(56) Entgegenhaltungen:
- EP-A- 0 589 699
- DD-A- 232 513
- DE-A- 3 906 374
- DE-C- 19 506 515
- US-A- 5 103 766

## Beschreibung

Die Erfindung betrifft ein Verfahren zur Herstellung wärmereflektierender Schichtsysteme auf transparenten Substraten, vorzugsweise auf Flachglas. Derartige Schichtsysteme haben ein hohes Transparenzverhalten im sichtbaren Spektralbereich. Die Schichtsysteme sollen je nach Anwendungszweck einen möglichst großen Teil des solaren Angebotsspektrums durchlassen und einen möglichst hohen Anteil der wesentlich niederenergetischen Raumtemperaturstrahlung reflektieren bzw. nur den sichtbaren Anteil des Sonnenspektrums durchlassen und alle Strahlung mit größerer Wellenlänge möglichst vollständig reflektieren. Das Schichtsystem wirkt als Wärmedämmung und Sonnenschutz. Derartig beschichtetes Flachglas wird vorzugsweise zur Fensterverglasung eingesetzt.

Es sind eine Vielzahl von Verfahren zur Herstellung von Wärmeschutzschichten wie auch Schichtsysteme aus den verschiedensten Materialien bekannt. Es hat sich gezeigt, daß Silber als Schichtmaterial, auch in Verbindung mit Schichten aus anderem Material, aus optischen und auch wirtschaftlichen Gründen sehr gut geeignet ist. Es sind Schichtsysteme mit Einzel-Silberschichten (EP 104 870; US 4,336,119) sowie Schichtsysteme mit Doppel-Silberschicht (DE 21 44 242; US 4,965,121) bekannt.

Es ist auch bekannt, die Silberschicht in einer reaktiven Atmosphäre aus Edelgas und Sauerstoff aufzubringen (DE 28 30 723 A 1). Dieses Verfahren hat den Nachteil, daß die Zerstäubungsrate zur Abscheidung der Metalloxidschicht an die entsprechende Atmosphäre angepaßt werden muß und damit als frei wählbare Prozeßgröße nicht mehr zur Verfügung steht.

Weiterhin ist es bekannt, ein Metalloxid unmittelbar auf eine Silberschicht aufzubringen. Das ist auch im mehrfachen Wechsel bekannt. Beim Aufbringen der Metalloxidschicht besteht die Gefahr einer Anoxidation der Silberschicht. Durch diese Beschädigung verliert die Silberschicht ihre guten Wärmereflektions- und Transmissionseigenschaften, zumindest teilweise.

Es ist bekannt, diesen Mangel zu beseitigen, indem vor dem reaktiven Sputtern der Metalloxidschicht eine dünne Metallschicht als sogenannter Blocker aus einem geeigneten Material, z.B. CrNi oder Ti, direkt auf die Silberschicht aufgebracht wird. Diese Blockerschicht verhindert im nachfolgenden Beschichtungsprozeß, einem reaktiven Zerstäubungsprozeß, eine Oxidation des Silbers und wird dabei selbst mehr oder weniger vollständig oxidiert. Nachteilig ist jedoch, daß in Abhängigkeit von der Art des Blockers und dessen erreichtem Oxidationsgrad ein Transmissionsverlust von einigen Prozent eintritt. Außerdem erhöht sich der anlagentechnische Aufwand, da ein zusätzlicher Bedarf an Raum in der Beschichtungsanlage und für die Stromversorgung ein höherer Aufwand erforderlich ist.
Es ist auch bekannt, die störende Anoxidation der Silberschicht durch eine langsame, das Silber energetisch weniger hoch belastende Abscheidung der Metalloxidschicht durch Aufdampfen weitgehend zu verhindern. Die damit verbundene geringe Produktivität und Wirtschaftlichkeit ist der größte Nachteil dieses Verfahrens. So wird zwar beschrieben, daß eine der Silberschicht folgende dünne Metallschicht die mechanische und thermische Widerstandsfähigkeit des Schichtsystems deutlich erhöht, aber diese setzt wiederum die Transmission herab, so daß letztendlich keine befriedigende Lösung gegeben ist.
Es ist auch bekannt, die Metalloxidschicht aus TiO₂ herzustellen, und diese durch reaktives Sputtern in Reaktivgasgemisch mit niedrigem Sauerstoffanteil aufzubringen, was zu unterstöchiometrischem TiO₂ führt (US 4,965,121). Die dabei beschriebene Methode der Gasgemischregelung führt unter Produktionsbedingungen zu keinem stabilen Betrieb und konnte bisher nur im Labormaßstab ausgeführt werden.

Eine weitere Möglichkeit besteht darin, bei der Herstellung eines Titanoxid-Silber-Titanoxid-Schichtsystems dem Argon-Sauerstoff-Gemisch einen Anteil Stickstoff beizugeben (DD 226 018 A 1). Der Nachteil bei diesem Verfahren besteht darin, daß unter praktischen Produktionsbedingungen kein stabiler Prozeß erzielt werden kann, da der Stickstoffanteil sehr genau dosiert und ständig nachgeregelt werden muß.

Weiterhin ist bekannt, ein spezielles Metalloxid - nämlich Nioboxid (DE 40 06 804 A 1) bzw. SnZr-Oxid (DE 39 06 374 A 1) - unmittelbar auf die Blockerschicht aufzubringen. Der Nachteil besteht einerseits darin, daß diese Materialien sehr kostenintensiv sind und andererseits diese Verfahren nur mit diesen speziellen Materialien durchführbar sind.

Der Erfindung liegt die Aufgabe zugrunde, ein Verfahren zur Herstellung wärmereflektierender Schichtsysteme auf transparenten Substraten, vorzugsweise Glas, zu schaffen, bei denen die Metalloxidschicht unmittelbar auf die darunterliegende Silberschicht, d.h. ohne eine zusätzliche Blockerschicht, mittels reaktivem Sputtern in einem Argon- / Sauerstoff-Gemisch aufgebracht wird. Es sollen keine Verluste in der integralen Transmission im sichtbaren Bereich bzw. der Reflexion im infraroten Bereich durch Anoxidation entstehen. Das Verfahren soll unter Produktionsbedingungen einfach ausführbar sein. Die Anlage zur Beschichtung soll keinen zusätzlich apparativen Aufwand gegenüber herkömmlichen Anlagen erfodern.

Erfindungsgemäß wird die Aufgabe nach den Merkmalen des Anspruches 1 gelöst. Weitere vorteilhafte Ausgestaltungen des Verfahrens sind in den Unteransprüchen 2 bis 6 beschrieben.

Das Schichtsystem wird wie bekannt aus wechselweise aufgebrachten Metall- und Metalloxidschichten aufgebaut. Die Metallschicht aus Silber wird wie bekannt aufgebracht, während die Metalloxidschicht durch reaktives Zerstäuben von Metall aufgebracht wird. Erfindungsgemäß wird die Metalloxidschicht durch wechselweises Abstäuben von zwei Metalltargets aufgestäubt. Dazu findet eine bekannte Dual-Magnetron-Sputterquelle (DMS genannt) Anwendung, die im Pulsbetrieb arbeitet. Es findet ein ständiger Wechsel der Polarität an den Metalltargets, den Zerstäubungselektroden, statt.
Es wurde überraschenderweise gefunden, daß durch dieses Umschalten, d.h. die Änderung der Polarität der Zerstäubungselektroden, beim Aufbringen der Metalloxidschicht der Partialdruck des Reaktivgases (Sauerstoff) wesentlich geringer gewählt werden kann, um eine ausreichende Oxidation zu erreichen. Es hat sich gezeigt, daß sich durch eine geeignete Variation der Sputterfrequenz der Reaktivgaseinlaß derart minimieren läßt, daß eine Oxidation der Silberschicht beim Aufbringen der Oxidschicht vermieden wird.

Der zum Betrieb der Dual-Magnetrons erforderliche Generator wird derart angepaßt, daß der Pulsbetrieb eine Anpassung der Polwechselfrequenz zwischen 30 und 100 kHz ermöglicht, da in diesem Bereich die besten Eigenschaften für das Schichtsystem erreichbar sind. Dieses Verfahren ermöglicht es, bei entsprechender Prozeßführung auf den Einsatz einer Blockerschicht zu verzichten, denn die Silberschicht wird vom Sauerstoff nicht angegriffen bzw. zerstört.

Zur Erhöhung der Betriebsstabilität ist es vorteilhaft, den Reaktivgaseinlaß in Abhängigkeit von optischen Parametern der Plasmaemission nachzuregeln. Hierzu ist der Einsatz des bekannten Plasma-Emissions-Monitors (PEM) besonders geeignet.

An einem Ausführungsbeispiel wird die Erfindung bzw. das erfindungsgemäß hergestellte Schichtsystem beschrieben.

Die zugehörigen Zeichnungen zeigen:
- Fig. 1:: ein beschichtetes Substrat mit einem Schichtsystem gemäß dem Stand der Technik mit Blockerschicht,
- Fig. 2:: ein beschichtetes Substrat ohne Blockerschicht,
- Fig. 3:: ein Diagramm über die Abhängigkeit des leistungsbezogenen Sauerstoffflusses von der Sputterfrequenz,
- Fig. 4:: ein Diagramm über die Transmissionswerte von wärmereflektierenden Schichtsystemen auf Glas.

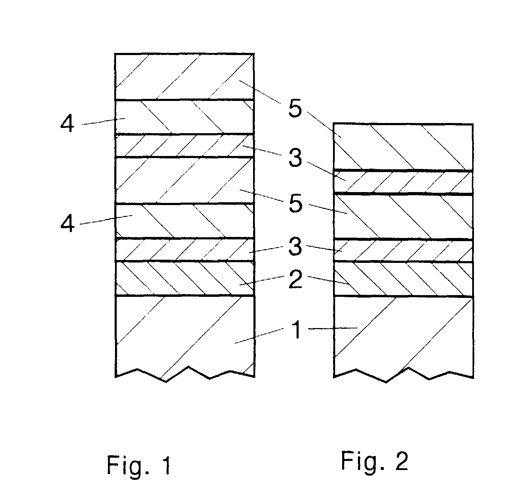

In den Fig. 1 und 2 ist der Aufbau eines Schichtsystems auf einem Substrat 1 aus Flachglas in bekannter Ausführung und gemäß der Erfindung gegenübergestellt.
Auf dem Substrat 1 ist eine Metalloxidschicht 2 aus TiO₂ durch reaktives Zerstäuben von Ti aufgestäubt. Auf diese wird eine Silberschicht 3 aufgestäubt. In der Ausführung nach dem Stand der Technik folgt eine Blockerschicht 4 aus NiCr, die verhindert, daß beim reaktiven Aufstäuben der Metalloxidschicht 5 aus TiO2 der Sauerstoff nicht die Silberschicht 3 zerstört. Erfindungsgemäß sind die Silberschichten 3 und Metalloxidschicht 5 im Wechsel direkt aufeinander aufgebracht. Als erste Schicht auf dem Substrat 1 ist immer eine Metalloxidschicht 2 aus TiO₂ aufgestäubt, die in gleicher Weise wie die Metalloxidschichten 5 aufgebracht wird. Das Schichtsystem schließt mit einer Metalloxidschicht 5 ab.
Die Metalloxidschichten 5 werden erfindungsgemäß durch Abstäuben von zwei Zerstäubungselektroden aus Ti erzeugt, wobei diese Zerstäubungselektroden einer Dual-Magnetron-Sputterquelle im Wechsel mit einer Frequenz von 50 kHz betrieben werden.

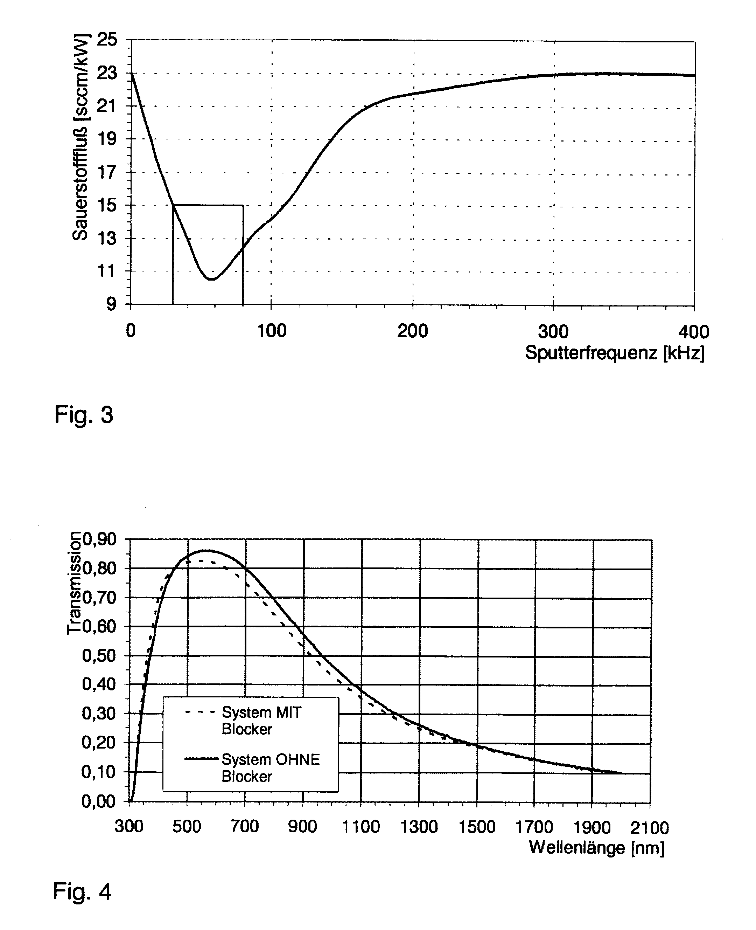

Aus Fig. 3 ist zu erkennen, wie der leistungsbezogene Sauerstofffluß von der Frequenz der Umpolung der Zerstäubungsfrequenz abhängt. Der markierte Bereich zeigt die erfindungsgemäßen Betriebsparameter für die Frequenz.

In Fig. 4 sind die Transmissionswerte des Schichtsystems nach dem Stand der Technik mit Blocker und einem Schichtsystem mit einer Silberschicht, das erfindungsgemäß aufgebracht ist, aufgezeigt.

## Patentansprüche

1. Verfahren zur Herstellung wärmereflektierender Schichtsysteme aus wechselweise aufgebrachten Silber- und Metalloxidschichten auf transparenten Substraten, insbesondere auf Glas, bei dem die Silberschicht im Vakuum aufgebracht und die hochbrechende Metalloxidschicht reaktiv aufgestäubt wird,
**dadurch gekennzeichnet**, daß jeweils nach Aufbringen der Silberschicht unmittelbar darauf die Metalloxidschicht durch wechselweises Abstäuben von zwei metallischen Zerstäubungselektroden reaktiv aufgebracht wird, wobei bei jedem Targetwechsel die Polarität an den metallischen Zerstäubungselektroden mit einer Frequenz zwischen 30 und 80 kHz gewechselt wird.

2. Verfahren nach Anspruch 1, **dadurch gekennzeichnet**, daß der Sauerstoff als Reaktivgas mit max. 15 sccm pro kW Zerstäubungsleistung zugeführt wird.

3. Verfahren nach Anspruch 1 und 2, **dadurch gekennzeichnet,** daß der Reaktivgaseinlaß mittels Plasma-Emissions-Monitor geregelt wird.

4. Verfahren nach Anspruch 1 bis 3, **dadurch gekennzeichnet**, daß die beiden Zerstäubungselektroden mit unterschiedlicher Energie gespeist werden und/oder die Sauerstoffpartialdrücke an den beiden Zerstäubungselektroden durch asymmetrischen Reaktivgaseinlaß eingestellt werden.

5. Verfahren nach Anspruch 1 bis 4, **dadurch gekennzeichnet**, daß zum Herstellen der Metalloxidschicht mindestens eine Zerstäubungselektrode aus Ti, Ta, Sn, Zn, Bi, Al, Si oder Zr oder einer diese Metalle enthaltenden Legierung reaktiv zerstäubt wird.

6. Verfahren nach mindestens einem der Ansprüche 1 bis 5, **dadurch gekennzeichnet**, daß als erste Schicht auf dem Substrat eine Metalloxidschicht durch wechselweises Abstäuben von zwei Zerstäubungselektroden aufgebracht wird.

7. Verfahren nach mindestens einem der Ansprüche 1 bis 6, **dadurch gekennzeichnet**, daß Zerstäubungselektroden unterschiedlicher chemischer Zusammensetzung zerstäubt werden.

## Claims

1. A process for producing heat-reflecting laminate systems of alternately applied silver and metal oxide layers on transparent substrates, in particular on glass, in which the silver layer is applied in a vacuum and the highly refractive metal oxide layer is applied by reactive sputtering, characterised in that in each case after application of the silver layer the metal oxide layer is reactively applied directly thereto by alternately sputtering away two metal sputtering electrodes, wherein in each target change the polarity is changed at the metal sputtering electrodes at a frequency of between 30 and 80 kHz.

2. A process according to claim 1 characterised in that oxygen is supplied as a reactive gas at a maximum of 15 sccm per kW of sputtering power.

3. A process according to claim 1 and claim 2 characterised in that the reactive gas inlet is regulated by means of plasma emission monitors.

4. A process according to claims 1 to 3 characterised in that the two sputtering electrodes are fed with different energy and/or the oxygen partial pressures at the two sputtering electrodes are adjusted by asymmetrical reactive gas inlet.

5. A process according to claims 1 to 4 characterised in that for producing the metal oxide layer at least one sputtering electrode of Ti, Ta, Sn, Zn, Bi, Al, Si or Zr or an alloy containing those metals is reactively sputtered.

6. A process according to at least one of claims 1 to 5 characterised in that a metal oxide layer is applied as the first layer on the substrate by alternate sputtering away of two sputtering electrodes.

7. A process according to at least one of claims 1 to 6 characterised in that sputtering electrodes of different chemical compositions are sputtered.

## Revendications

1. Procédé de fabrication d'un système de couches réfléchissant la chaleur, constitué de couches alternées d'argent et d'oxyde de métal, déposées sur un substrat transparent, notamment en verre et sur lequel la couche d'argent est déposée sous vide et la couche d'oxyde de métal hautement friable est déposée par une pulvérisation réactive, caractérisé en ce qu'après chaque dépôt d'une couche d'argent, la couche d'oxyde de métal est déposée directement par pulvérisation réactive faite de manière alternée depuis deux électrodes métalliques de pulvérisation, et en ce que, lors de chaque changement de cible, la polarité des deux électrodes métalliques de pulvérisation est changée avec une fréquence comprise entre 30 et 80 kHz.

2. Procédé selon la revendication 1, caractérisé en ce que l'oxygène utilisé comme gaz réactif est amené avec un débit maximum de 15 sccm par kW de puissance de pulvérisation.

3. Procédé selon les revendications 1 et 2, caractérisé en ce que l'admission du gaz réactif est réglée par un moniteur d'émission du plasma.

4. Procédé selon l'une des revendications de 1 à 3, caractérisé en ce que les deux électrodes de pulvérisation sont alimentées avec des énergies différentes et/ou que les pressions partielles de l'oxygène aux deux électrodes de pulvérisations sont réglées par une admission asymétrique du gaz réactif.

5. Procédé selon les revendications 1 à 4 caractérisé en ce que, pour la réalisation de la couche en oxyde de métal, on utilise au moins une électrode de pulvérisation réactive en Ti, Ta, Sn, Zn, Bi, Al, Si, ou Zr ou en un alliage contenant un de ces métaux.

6. Procédé selon au moins l'une des revendications de 1 à 5, caractérisé en ce que l'on dépose en tant que première couche sur le substrat, une couche d'oxyde de métal, par une pulvérisation alternée depuis deux électrodes de pulvérisation.

7. Procédé selon au moins l'une des revendications 1 à 6, caractérisé en ce que les électrodes de pulvérisation projettent des compositions chimiques différentes.
